# EUROPÄISCHE PATENTANMELDUNG

(11) **EP 0 679 729 A1**
(43) Veröffentlichungstag der Anmeldung: **02.11.1995**
(21) Anmeldenummer: 95104417.1
(22) Anmeldetag: 24.03.1995
(51) Int. Cl.: C23C 14/08, C23C 14/10, A47G 21/00, A47G 21/02

(54) **Verfahren zur Verhinderung des Anlaufens von Gegenständen**

(30) Priorität: 29.04.1994 DE 4415122
(71) Anmelder: WMF WÜRTTEMBERGISCHE METALLWARENFABRIK AG, D-73309 Geislingen/Steige (DE)
(72) Erfinder: Fehse, Hans-Friedrich, Dr. Ing., D-73326 Deggingen (DE); Wend, Eike, Dr. Ing., D-73033 Göppingen (DE); Dimigen, Heinz, Prof. Dr., D-22605 Hamburg (DE); Jung, Thomas, Dr., D-25474 Ellerbeck (DE)
(74) Vertreter: Grünecker, Kinkeldey, Stockmair & Schwanhäusser Anwaltssozietät

(57) **Zusammenfassung**

Die Erfindung betrifft ein Verfahren zur Verhinderung des Anlaufens von Gegenständen, wie z.B. Zier- und Gebrauchsgegenständen für den Haushalt, mit überwiegend silberhaltiger Oberfläche.

Um das Anlaufen solcher Gegenstände dauerhaft zu verhindern, werden die Gegenstände mit einer transparenten Hartstoffschicht, vorzugsweise auf der Basis Si0₂ oder Al₂0₃, überzogen.

## Beschreibung

Die Erfindung betrifft ein Verfahren zur Verhinderung des Anlaufens von Gegenständen, wie z.B. Zier- und Gebrauchsgegenständen im Haushalt, mit überwiegend silberhaltiger Oberfläche.

Der Wunsch, Silberoberflächen von Gegenständen, wie sie insbesondere im Haushalt als Zier- und Gebrauchsgegenstände verwendet werden, z.B. Silberbesteck, Silberteller, Silbervasen und dergl.gegen Anlaufen zu schützen besteht seit Jahrhunderten. Sehr viele Vorschläge sind deshalb schon bekannt geworden, die darauf abzielen, die Oberfläche von Gegenständen mit Silberoberfläche oder von Echtsilbergegenständen gegen Anlaufen zu schützen.

Eine erste Gruppe von umfangreichen Untersuchungen ging darauf hinaus, dem Silber Komponenten zuzulegieren, um einen permanten Anlaufschutz zu erreichen. Alle diesbezüglichen Versuche sind jedoch gescheitert.

Eine zweite Gruppe von Vorschlägen versuchte, auf chemischem Wege den Anlauf zu verhindern. Durch die Behandlung der Oberflächen mit Merkaptanverbindungen konnte die Anlaufbeständigkeit etwas erhöht werden. Beim Tragen der Gegenstände, beim Abstauben oder auch beim Waschen der Silberteile, insbesondere in Geschirrspülmaschinen, wird der Auftrag jedoch entfernt und muß erneuert werden, was einem Putzen gleich kommt. Deshalb wird auch mit dieser zweiten Gruppe von Vorschlägen keine dauerhafte Lösung geschaffen.

Eine dritte Gruppe von Bemühungen ging dahin, Silbergegenstände mit einem Klarlack zu überziehen. Ein solcher Vorschlag wird z.B. in der europäischen Patentschrift 0042 077 beschrieben. Auch hier läßt jedoch die Dauerhaftigkeit und Beständigkeit des Anlaufschutzes zu wünschen übrig.

Aufgabe der Erfindung ist es daher, ein Verfahren der eingangs genannten Art anzugeben, mit dem dauerhaft das Anlaufen von Gegenständen mit überwiegend silberhaltiger Oberfläche verhindert wird.

Die Lösung dieser Aufgabe liegt darin, die Gegenstände mit einer transparenten Hartstoffschicht zu überziehen.

Es hat sich herausgestellt, daß ein Überzug aus einer Hartstoffschicht einen sehr dauerhaften Schutz auch bei starker mechanischer und chemischer (Geschirrspülmaschine) Beanspruchung der Gegenstände schaffen kann. Ein Überzug aus einer Hartstoffschicht ist äußerst kratzfest, wasserunlöslich und reagiert nicht mit im Haushalt verwendeten, üblichen Chemikalien. Außerdem sind Hartstoffschichten gesundheitlich völlig unbedenklich und ein Überzug aus Hartstoff eignet sich damit insbesondere auch für Bestecke.

Als Hartstoffschichten (Schichten im Härtebereich von > 1000 N/mm²) kommen insbesondere Hartstoffschichten auf der Basis Si0₂, Al₂o₃ in Frage, andere Materialien wie Zirkonoxid (Zr0₂), Titanoxid (TiO₂), Hafniumoxid (HfO₂) und Tantaloxid sind aber ebenfalls denkbar.

Die Hartstoffschicht wird bevorzugt in einem Depositionsverfahren aufgebracht. Prinzipiell eignen sich die meisten bekannten Depositionsverfahren für diesen Zweck, es hat sich jedoch herausgestellt, daS sich insbesondere das Hohlkathodensputtern als besonders geeignet erwiesen hat. Beim Hohlkathodensputtern brennt in einer Hohlkathode eine Hohlkathodenglimmentladung. Dabei wird Kathodenmaterial abgetragen. Dieses Material wird mittels eines Inertgasstromes aus der Hohlkathode hinaustransportiert. Außerhalb der Hohlkathode wird das erforderliche Reaktionsprodukt hinzugefügt, so daS sich schließlich auf der Gegenstandsoberfläche, die sich außerhalb der Kathode, aber im oder nahe am Inertgasstrom befindet, das Reaktionsprodukt bildet oder niederschlägt. Dieses Verfahren ermöglicht gerade bei den erwähnten Oxidschichten (Hartstoffschichten) eine hohe Beschichtungsrate und damit eine wirtschaftliche Beschichtung der in Rede stehenden Gegenstände. Das Hohlkathodensputtern ist an sich bekannt und wird z.B. in der deutschen Offenlegungsschrift 42 10 125 beschrieben.

Es hat sich herausgestellt, daß eine ausreichende Haftfestigkeit insbesondere dann erreicht wird, wenn vor dem Aufbringen der Hartstoffschicht die Gegenstandsoberfläche erwärmt wird, vorzugsweise auf etwa 100 bis 200^{o} C. Das Aufbringen geschieht vorzugsweise bei einem Druck zwischen 10⁻¹ bis 10⁻⁶ Millibar (10 Pa bis 10⁻⁴ Pa), vorzugsweise zwischen 10⁻¹ Millibar und 10⁻³ Millibar (10 Pa und 10⁻¹ Pa). Durch den im Vergleich zu anderen Beschichtungsverfahren relativ hohen Arbeitsdruck und die strömungsbedingte Ausbreitung des Plasmas wird die Voraussetzung für eine besonders haftfeste, spannungsarme und porenfreie Beschichtung geschaffen. Andererseits liegt der Druck in den angegebenen Grenzen noch so niedrig, daß das Vorhandensein von Fremdstoffen, insbesondere Sauerstoff ausgeschlossen wird.

Eine besonders gute Haftfestigkeit der Hartstoffschicht, die insbesondere bei Gegenständen erforderlich ist, die häufiger dem alkalischen oder oxidierenden Milieu von Haushaltsgeschirrspülmaschinen ausgesetzt werden, wie z.B. Bestecke oder Teller, wird erreicht, wenn dafür gesorgt wird, daß die Gegenstandsoberfläche vor dem Aufbringen der Hartstoffschicht völlig rein, insbesondere frei von Adsorbaten ist. Geringe Mengen von Wassermolekühlen auf der Oberfläche würde bereits die chemische Beständigkeit stark schwächen. Deshalb ist es insbesondere in diesem Fall von Vorteil, wenn vor dem Aufbringen der Hartstoffschicht eine vollständige Entfernung von Wasserresten auf der Oberfläche vorgenommen wird. Dies kann z.B. dadurch geschehen, daß die Gegenstände vor dem eigentlichen Aufbringen der Hartstoffschicht kurzzeitig sehr stark (100-200^{o}C) erhitzt werden oder daß sie kurzzeitig einem Hochvakuum ausgesetzt werden, um die restlichen Wasseratome zu entfernen. Eine solche Behandlung führt auch ohne die aufwendigere Anwendung spezieller Reduziergase wie z.B. H₂ zu einer hervorragenden Reinheit der Gegenstandsoberfläche und läßt sich einfach erreichen. Die Hartstoffschicht wird vorzugsweise mit Schichtstärken zwischen 0,1 und 10 µm, insbesondere zwischen 0,8 und 2 µm aufgebracht. Bei diesen dünnen Schichten wird die mechanische Oberflächenbeschaffenheit nach wie vor im wesentlichen durch das Verhalten des Grundwerkstoffes, also der Silberoberfläche, bestimmt, andererseits wird mit diesen Schichtstärken beeits ein wirksamer Anlaufschutz mit hoher Kratzbeständigkeit geschaffen.

Mit diesen Schichtstärken wird außerdem eine porenfreie Beschichtung bereits erzielt.

## Patentansprüche

1. Verfahren zur Verhinderung des Anlaufens von Gegenständen, wie z.B. Zier- und Gebrauchsgegenständen im Haushalt, mit überwiegend silberhaltiger Oberfläche, **dadurch gekennzeichnet**, daß die Gegenstände mit einer transparenten Hartstoffschicht überzogen werden.

2. Verfahren nach Anspruch 1, **dadurch gekennzeichnet**, daß die Gegenstände mit einer Hartstoffschicht auf der Basis Si0₂ oder Al₂0₃ überzogen werden.

3. Verfahren nach Anspruch 1 oder 2, **dadurch gekennzeichnet**, daß die Hartstoffschicht in einem Depositionsverfahren aufgebracht wird.

4. Verfahren nach Anspruch 3, **dadurch gekennzeichnet**, daß die Hartstoffschicht durch Hohlkathodensputtern aufgebracht wird.

5. Verfahren nach Anspruch 3 oder 4, **dadurch gekennzeichnet**, daß die Gegenstandsoberfläche vor dem Aufbringen der Hartstoffschicht erwärmt wird, vorzugsweise auf etwa 100 bis 200^{o}C.

6. Verfahren nach Anspruch 4 oder 5, **dadurch gekennzeichnet**, daß das Aufbringen der Hartstoffschicht bei einem Druck zwischen 10⁻¹ bis 10⁻⁶ Millibar (10 Pa und 10⁻⁴ Pa) vorzugsweise zwischen 10⁻¹ und 10⁻³ Millibar (10 Pa und 10⁻¹ Pa) durchgeführt wird.

7. Verfahren nach wenigstens einem der Ansprüche 3 bis 6, **dadurch gekennzeichnet**, daß vor dem Aufbringen der Hartstoffschicht eine vollständige Entfernung von Adsorbaten, insbesondere Wasserresten, auf der Oberfläche vorgenommen wird.

8. Verfahren nach wenigstens einem der vorangegangenen Ansprüche, **dadurch gekennzeichnet**, daß die Hartstoffschicht mit Schichtstärken zwischen 0,1 und 10 µm, insbesondere zwischen 0,8 und 2 µm aufgebracht wird.

9. Gegenstand, insbesondere Zier- und Gebrauchsgegenstand für den Haushalt, mit überwiegend silberhaltiger Oberfläche, die mit einer Hartstoffschicht überzogen ist.
